Europäisches Patentamt

European Patent Office

Office européen des brevets

(19)

(11) EP 1 291 661 A1

(12) **DEMANDE DE BREVET EUROPEEN**

(43) Date de publication:
**12.03.2003 Bulletin 2003/11**

(51) Int Cl.⁷: $G01R\ 31/00$

(21) Numéro de dépôt: **02292182.9**

(22) Date de dépôt: **05.09.2002**

(84) Etats contractants désignés:
**AT BE BG CH CY CZ DE DK EE ES FI FR GB GR
IE IT LI LU MC NL PT SE SK TR**
Etats d'extension désignés:
**AL LT LV MK RO SI**

(30) Priorité: **06.09.2001 FR 0111558**

(71) Demandeur: **Peugeot Citroen Automobiles SA
92200 Neuilly sur Seine (FR)**

(72) Inventeur: **Loisel, Laurent
78720 La Celle Les Bordes (FR)**

(74) Mandataire: **Grynwald, Albert
Cabinet Grynwald,
127, rue du Faubourg Poissonnière
75009 Paris (FR)**

(54) **Procédé et dispositif de controle d'organes électriques à bord d'un véhicule**

(57)    L'invention concerne un procédé de contrôle d'organes ($32_j$) embarqués dans un véhicule (30) comprenant au moins une batterie (29) pour alimenter ces organes ($32_j$) en énergie électrique et une unité centrale (35) pour mémoriser les commandes transmises à ces derniers.

Ce procédé est caractérisé en ce qu'on mesure sur un conducteur ($C_{31}$) d'alimentation reliant la batterie (29) aux organes ($32_j$) commandés au moins un signal représentatif de l'état de fonctionnement de ces organes ($32_j$) et en ce qu'on compare cet état à l'état de fonctionnement déterminé par les commandes mémorisées dans l'unité centrale (35).

FIG_2

EP 1 291 661 A1

## Description

L'invention concerne un procédé et un dispositif de contrôle d'organes à commande électrique embarqués à bord d'un véhicule.

Un véhicule comprend de nombreux organes commandés électriquement tels que les essuie-glaces, les feux de position et d'éclairage, les indicateurs de direction, la radio, la climatisation, etc. A cet effet, chacun de ces organes est relié à un activateur commandé par le conducteur et/ou de façon automatique selon un mode décentralisé ou centralisé.

Dans une commande décentralisée, l'activateur est directement relié à l'organe.

Dans une commande centralisée, les signaux de commande de l'activateur sont transmis à l'organe à commander par l'intermédiaire d'une unité centrale, par exemple un microprocesseur.

Une commande centralisée permet, grâce à une programmation de l'unité centrale, de corréler une commande manuelle avec une commande automatique. Par exemple, on peut programmer l'unité centrale pour que l'essuie-glace arrière soit automatiquement activé lorsque l'essuie-glace avant est activé et que la marche arrière du véhicule est enclenchée.

De plus, une commande centralisée simplifie l'architecture du réseau de commande puisqu'elle permet de relier plusieurs organes à l'unité centrale par un même circuit de commande à multiplexage.

En raison de ces avantages la commande centralisée est de plus en plus utilisée. On notera cependant qu'une commande centralisée n'entraîne pas forcément l'utilisation d'une seule unité centrale. On peut prévoir, par exemple, qu'une unité centrale commande les organes proches du moteur tandis qu'une autre unité centrale commande les organes de l'habitacle.

Quel que soit le mode de commande, centralisé ou non, le fonctionnement des organes électriques peut être contrôlé de façon manuelle ou automatique.

Le contrôle manuel, dit de diagnostic, consiste à activer et désactiver successivement chaque organe et à mesurer le courant délivré par la batterie après chaque activation. Ces mesures sont comparées à des courants d'alimentation théoriquement nécessaires au fonctionnement correct de chaque organe et, si la valeur du courant mesuré pour un organe diffère de la valeur attendue, un dysfonctionnement de cet organe est diagnostiqué. Un contrôle manuel est long, coûteux et peu fiable.

Ce mode de contrôle n'est pas utilisé pour un véhicule en fonctionnement où plusieurs organes peuvent être activés simultanément, une mesure du courant d'alimentation ne pouvant pas être attribuée spécifiquement au fonctionnement d'un organe. C'est pourquoi, on fait appel à un dispositif d'auto-diagnostic pour contrôler les divers organes d'un véhicule en fonctionnement, c'est-à-dire lorsque le "contact" est mis.

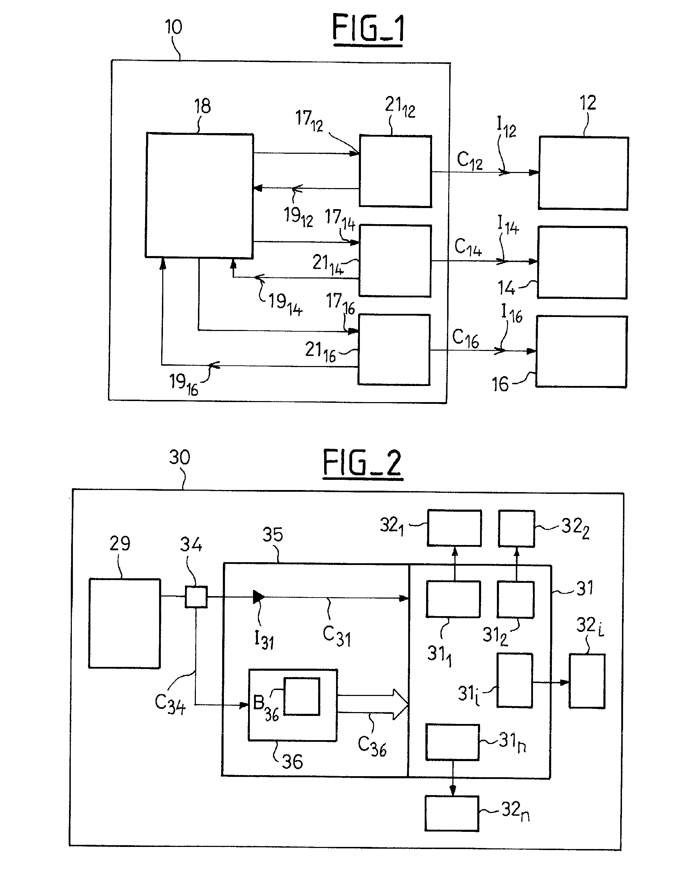

Un dispositif de contrôle et de commande connu, représenté sur la figure 1, comprend une unité centrale 10 (figure 1) alimentant des organes 12, 14 et 16 reliés à cette dernière par des connexions respectives $C_{12}$, $C_{14}$ et $C_{16}$ transmettant le courant d'alimentation $I_{12}$, $I_{14}$ ou $I_{16}$ respectif à chaque organe 12, 14 ou 16.

L'émission de ces courants $I_{12}$, $I_{14}$ et $I_{16}$ est déclenchée par un processeur 18 compris dans l'unité centrale 10, par exemple en fonction de signaux de commande émis par des actionneurs (non représentés) de ces organes 12, 14 ou 16. Ce processeur émet des signaux $17_{12}$, $17_{14}$, $17_{16}$ de commande à des éléments de régulation $21_{12}$, $21_{14}$ et $21_{16}$. Chaque élément de régulation $21_j$ délivre, en fonction du signal de commande $17_j$, l'intensité requise $I_j$ à l'organe j via la connexion Cj.

Des signaux $19_{12}$, $19_{14}$ ou $19_{16}$ de diagnostic émis par chaque élément $21_{12}$, $21_{14}$ ou $21_{16}$ vers le processeur 18 informent ce dernier du fonctionnement de chaque organe i. Pour cela, chaque élément $21_i$ contrôle que l'intensité $I_j$ délivré à l'organe j corresponde à l'intensité nécessaire au fonctionnement de cet organe en accord avec l'état de fonctionnement commandé. Par exemple, si l'organe 14 est une ampoule nécessitant un courant de 5 mA lorsqu'elle est activée, l'élément $21_{14}$ vérifie que, dans ce cas, le courant d'alimentation $I_{14}$ a une intensité de 5 mA.

Si le processeur 18 est informé par un élément $21_i$ de la défaillance d'un organe, il déclenche une procédure préprogrammée correspondant au type de défaillance identifié et à l'organe concerné. Par exemple, si le processeur 18 est informé d'une trop faible consommation de l'ampoule 14, il informe l'utilisateur du véhicule d'une possible panne de cette ampoule au moyen d'une voix de synthèse ou d'un voyant.

Ce mode de contrôle continu présente l'inconvénient de nécessiter un flux important de signaux de diagnostic $19_j$ que l'unité centrale doit traiter. Ce flux requiert l'utilisation de nombreuses connexions et d'un processeur complexe, le dispositif de contrôle étant alors de coût élevé.

L'invention remédie à cet inconvénient. Elle concerne un procédé de contrôle d'organes embarqués dans un véhicule comprenant au moins une batterie pour alimenter ces organes en énergie électrique et une unité centrale pour mémoriser les commandes transmises à ces derniers. Ce procédé est caractérisé en ce qu'on mesure sur un conducteur d'alimentation reliant la batterie aux organes commandés au moins un signal représentatif de l'état de fonctionnement de ces organes et en ce qu'on compare cet état à l'état de fonctionnement déterminé par les commandes mémorisées dans l'unité centrale.

Si l'état de fonctionnement mesuré ne correspond pas à l'état de fonctionnement mémorisé, les organes contrôlés ne fonctionnent pas correctement et une panne est diagnostiquée.

Avec un tel procédé, on contrôle des organes sans la transmission de signaux de diagnostics propres à chaque organe, tels que les signaux $19_i$ de la figure

1, puisqu'on contrôle l'ensemble de ces organes à partir d'un seul signal. Le flux de signaux traités par l'unité centrale est alors fortement réduit, sa fiabilité de fonctionnement augmentant par sa simplification.

En outre, ce procédé permet un contrôle de diagnostic de type automatique, qui est fiable et peu onéreux.

Selon un premier mode de réalisation, particulièrement simple, le signal représentatif de l'état de fonctionnement est l'intensité du courant dans ledit conducteur. En outre, la comparaison est effectuée à la suite d'une commande d'un organe. Par exemple, si les feux de croisement sont mis en route, leur actionnement correspond à un appel de courant prédéterminé. Si cet appel de courant prédéterminé est détecté, le fonctionnement des feux peut être considéré comme correct ; par contre, si la variation de courant mesurée est sensiblement supérieure ou inférieure à une valeur attendue, une panne est diagnostiquée.

Dans une réalisation, ce signal représentant l'état de fonctionnement est l'intensité du courant électrique fourni par la batterie et/ou la variation de cette intensité quand un organe contrôlé est activé ou désactivé.

Dans un mode de réalisation, la détermination de l'intensité du courant n'est prise en compte que lorsque cette intensité est stable sur une période prédéterminée.

Dans ce cas on prévoit une réalisation telle que, pour détecter la stabilité du courant, on effectue une analyse spectrale de ce dernier, par exemple par une Transformée de Fourier Discrète, le signal étant considéré stable quand les harmoniques sont nuls ou négligeables.

Dans le cas où le véhicule comporte des organes pour lesquels les commandes ne sont pas mémorisées dans l'unité centrale, on prévoit une réalisation telle que l'intensité du courant peut être détectée dans une dérivation alimentant uniquement des organes contrôlés.

Selon un mode de réalisation, on prend en compte des délais prédéterminés de réception des signaux de commande par les organes commandés et des délais de stabilisation du courant avant de déterminer une mesure du courant, de telle sorte que si ces délais ne sont pas respectés, le contrôle est retardé ou annulé.

Dans une réalisation, on prend en compte des incertitudes ou tolérances du courant, par exemple dues aux organes en fonctionnement, de telle sorte que la variation de courant n'est considérée dans le contrôle d'un organe que si elle est supérieure à ces incertitudes ou tolérances.

Ce procédé de contrôle, qui ne donne entière satisfaction que lorsqu'il est effectué au moment de la commande de l'actionnement d'un organe, répond aux attentes de la plupart des usagers.

Bien que, comme indiqué ci-dessus, cette altération des performances ne soit pas vraiment gênante en pratique, on prévoit un second mode de réalisation pour permettre un contrôle permanent des organes. Dans ce cas, on affecte à chaque organe un signal caractéristique transmis sur le conducteur d'alimentation, ce signal étant présent (ou absent) lorsque l'organe est activé et absent (ou présent) lorsque l'organe est désactivé.

Dans une réalisation, ce signal caractéristique est un signal à fréquence constante, cette fréquence étant propre à un organe.

On prévoit alors une réalisation telle que l'analyse spectrale est aussi utilisée pour détecter les fréquences propres aux organes.

Quel que soit le mode de réalisation, ce procédé s'applique avantageusement dans le cas où le véhicule comporte un réseau de commande centralisé puisque l'unité centrale commande le fonctionnement des organes électriques et peut être développée, par simple programmation, pour effectuer une comparaison entre valeurs attendues.

C'est pourquoi, selon une réalisation, les organes sont commandés à partir de l'unité centrale.

Par ailleurs, la comparaison entre l'état de fonctionnement déterminé à partir du signal prélevé et l'état de fonctionnement mémorisé peut être effectuée dans l'unité centrale dans une réalisation.

L'invention concerne aussi un véhicule comprenant une batterie pour alimenter ces organes en énergie électrique et une unité centrale pour mémoriser les commandes transmises à ces derniers. Ce véhicule est caractérisé en ce qu'il comprend des moyens pour la mise en oeuvre du procédé tel que défini ci-dessus.

Finalement, l'invention est aussi relative à un dispositif de contrôle et d'alimentation électrique d'organes à bord d'un véhicule, comprenant une batterie pour alimenter ces organes en énergie électrique et une unité centrale pour mémoriser les commandes transmises. Un tel dispositif est caractérisé en ce qu'il comprend des moyens pour la mise en oeuvre du procédé tel que défini ci-dessus.

D'autres caractéristiques et avantages de l'invention apparaîtront avec la description de certains de ses modes de réalisation, celle-ci étant effectuée en se référant aux dessins ci-annexés sur lesquels :

la figure 1, déjà décrite, représente un dispositif connu de contrôle par auto-diagnostic d'organes électriquement commandés,
la figure 2 représente un dispositif de contrôle conforme à l'invention,
la figure 3 représente un dispositif de contrôle conforme à l'invention adapté à un véhicule comportant plusieurs unités centrales,
la figure 4 est un schéma d'une sonde de mesure de courant utilisée dans un dispositif conforme à l'invention,
la figure 5 est un organigramme d'opérations effectuées dans un procédé conforme à l'invention,

les figures 6a, 6b et 6c représentent des chronogrammes des opérations d'une réalisation conforme à l'invention,

la figure 7 représente un enregistrement de mesures et de leur analyse conformément à l'invention, et

la figure 8 représente un mode de réalisation de l'invention permettant le contrôle continu d'organes.

Sur la figure 2 un rectangle 30 représente de façon symbolique un véhicule équipé d'une batterie 29 alimentant des organes $32_1$, $32_2$, ...$32_j$... $32_n$. Cette alimentation électrique est transmise sous la forme d'un courant électrique d'intensité $I_{31}$ qui, via un conducteur $C_{31}$, relie la batterie 29 à l'ensemble 31 des éléments de régulations $31_j$ d'une unité centrale 35. Chacun de ces éléments $31_j$ alimente par la suite un organe $32_j$ lorsqu'un élément $31_j$ reçoit une commande d'activation comme décrit ultérieurement.

Un capteur 34 de courant sur ce conducteur $C_{31}$ mesure l'intensité du courant $I_{31}$ fourni par la batterie 29 à l'ensemble 31 d'éléments de régulation, un conducteur $C_{34}$ reliant ce capteur 34 à un processeur 36 compris dans l'unité centrale 35.

Ce processeur 36 commande les organes électriques $32_1$, $32_2$, ...$32_j$..., $32_n$ du véhicule. A cet effet, il est relié à l'ensemble 31 au moyen d'un bus $C_{36}$ transmettant des signaux de commande aux éléments $31_j$.

Le fonctionnement d'un organe peut être défini par un ou plusieurs critères (son état activé, "marche", ou désactivé, "arrêt", un niveau de puissance utilisée, etc). Pour simplifier la description, on supposera dans ce qui suit que le fonctionnement d'un organe est défini par son seul état d'activation, "marche" ou "arrêt". Mais bien entendu l'invention n'est pas limitée à cet exemple simplifié.

Le processeur 36 comprend une base $B_{36}$ de données dans laquelle sont mémorisées les valeurs de chaque intensité $i_{th}(32_j)$ théoriquement nécessaire au fonctionnement de chaque organe $32_j$. A partir de cette base, et connaissant l'état, "marche" ou "arrêt", de chaque organe $32_j$, la valeur théorique du courant $I_{th}$ nécessaire à l'alimentation des organes $32_1$, $32_2$, ...$32_j$..., $32_n$ est déterminée par ce processeur 36 en sommant les intensités théoriques nécessaires au fonctionnement des organes $32_j$ activés. Ces valeurs théoriques peuvent tenir compte de divers paramètres tels que la résistance interne des connecteurs, le vieillissement du réseau, etc.

Un organe $32_j$ est contrôlé lorsqu'une commande d'activation ou de désactivation de cet organe est émise par l'unité centrale. Dès lors, cette dernière compare la variation de l'intensité du courant $I_{31}$ mesurée avec la variation théorique $I_{th}$ déterminée comme décrit dans l'exemple ci-dessous.

Dans cet exemple, on suppose que l'organe $32_j$ nécessite, pour fonctionner, un courant d'une intensité $i_{th}(32_j)$ connue. Lorsque le processeur 36 transmet une commande d'activation à l'élément $31_j$ de régulation de cet organe $32_j$ via le conducteur $C_{36}$, ce processeur 36 mesure les variations de l'amplitude du courant d'alimentation $I_{31}$ parallèlement à l'exécution de la commande.

Si la commande d'activation est correctement exécutée par l'élément $31_j$ et que l'organe consomme un courant $i_{32j}$ correspondant à $i_{th}(32_j)$, l'intensité du courant $I_{31}$ délivré par la batterie 29 augmente d'une valeur $i_{th}(32_j)$. Le processeur 36, constatant l'égalité entre la variation mesurée du courant et la variation attendue, diagnostique un fonctionnement correct de l'organe $32_j$.

Au contraire, si la variation de l'intensité $I_{31}$ mesurée par le capteur 34 est différente de la variation attendue $i_{th}(32_j)$, le processeur 36 conclut à une défaillance dans le dispositif d'alimentation de l'organe $32_j$. Cette défaillance peut être due à un dysfonctionnement de la batterie 29, du conducteur $C_{31}$, de l'élément $31_j$ ou de l'organe $32_j$. Le processeur 36 déclenche alors des commandes préprogrammées, par exemple pour recommander, au moyen d'un signal tel qu'une voix de synthèse, à l'utilisateur du véhicule de se diriger vers un garage.

Le dispositif décrit à la figure 2 fait appel à une batterie 29 pour alimenter un ensemble d'organes $32_1$, $32_2$, ...$32_j$..., $32_n$ commandés par une même unité centrale 36. Toute variation de l'intensité $I_{31}$ est due à une mise en marche ou un arrêt d'un organe $32_j$.

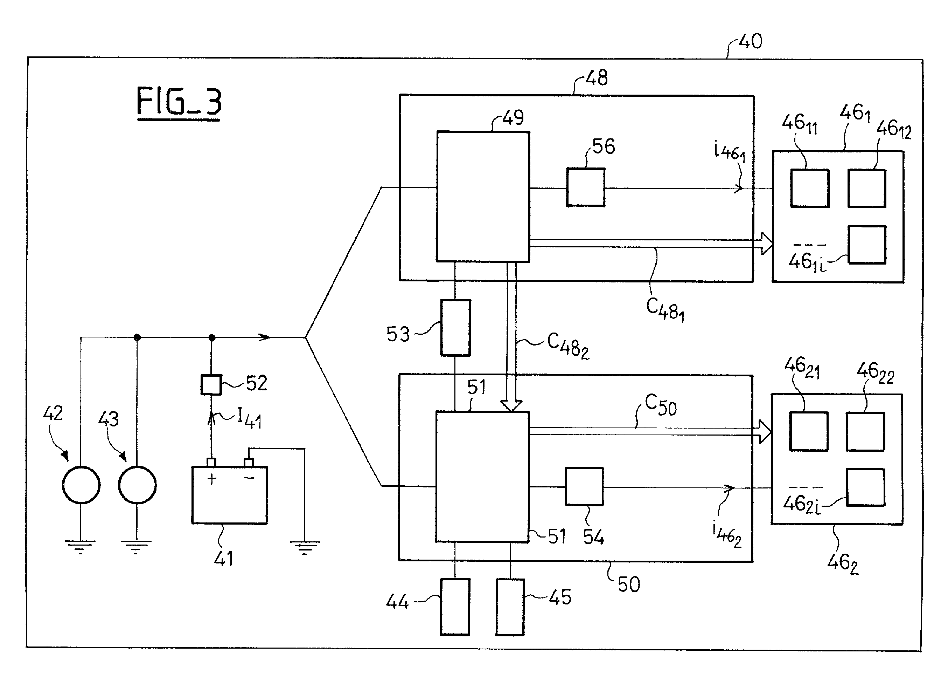

Toutefois, l'ensemble des organes électriques d'un véhicule n'est pas toujours commandé par un même élément et/ou alimenté par un même générateur. Une pluralité de capteurs de courant sont alors nécessaires pour déterminer la variation de courant associée uniquement à la modification du fonctionnement d'un organe, comme montré sur la figure 3.

Dans cet exemple, le réseau d'un véhicule 40 comprend une batterie 41, des unités centrales 48 et 50 et plusieurs types d'organes :

Des organes 42 et 43 d'un premier type sont directement reliés à la batterie 41 ; ils ne reçoivent pas de signaux de commande de l'unité centrale 48. Ces organes sont, par exemple, un alternateur 42 et un démarreur 43 commandés par des actionneurs (non représentés) selon un mode de commande décentralisé.

Un ensemble $46_1$ d'organes $46_{11}$, $46_{12}$,..., $46_{1k}$ et un ensemble $46_2$ d'organes $46_{21}$, $46_{22}$,..., $46_{2k'}$, constituant un second type, à savoir des organes commandés par l'unité centrale 48 via des connexion $C_{481}$ et $C_{482}$. Les ensembles d'organes $46_1$ et $46_2$ ne sont pas directement alimentés par la batterie 41 mais via le processeur 49 de l'unité centrale 48 - pour l'ensemble d'organes $46_1$ - ou via le processeur 51 de l'unité annexe 50 telle qu'une unité moteur, pour l'ensemble d'organes $46_2$. Pour des raisons de clarté, les éléments de régulation associés aux organes $46_{1j}$ et $46_{2j'}$ ne sont pas représentés.

Des organes 44 et 45 tels qu'un allume-cigares et un rétroviseur qui, alimentés via le processeur 51, sont directement commandés par des actionneurs non représentés.

Un capteur 52 détecte le courant à la sortie de la batterie 41. Ce capteur est utilisé lors des contrôles de type diagnostic où chaque organe est testé successivement. Ainsi, lorsqu'un organe est activé puis désactivé, le capteur 52 mesure le courant $I_{41}$ fourni par la batterie 41 et, en comparant le courant mesuré avec le courant théoriquement requis lors de l'activation de cet organe, on contrôle le fonctionnement de cet organe.

L'utilisation d'un capteur 52 à la sortie de la batterie 41 doit tenir compte de l'éventuelle présence d'organes fortement consommateurs d'électricité et de la nécessité de diagnostiquer la charge ou la décharge de la batterie. En d'autres termes, un tel capteur 52 doit pouvoir mesurer des courants élevés, de l'ordre de 100 ampères, et mesurer le sens de ces courants.

Ce capteur étant installé en permanence dans le véhicule, il permet un contrôle de diagnostic qui évite l'installation de capteurs par un opérateur comme dans l'état antérieur de la technique. De plus, lorsque l'organe testé est un organe $46_{1j}$ ou $46_{2j}$, commandé par le processeur 49, ce dernier peut effectuer automatiquement l'opération de diagnostic (activation, mesure, désactivation et diagnostic), par exemple conformément à une programmation spécifique.

Ces organes $46_{1j}$ et $46_{2j}$, sont aussi contrôlés en mode auto-diagnostic, c'est-à-dire indépendamment du fonctionnement d'autres organes. Une difficulté dans l'exécution de ce contrôle réside dans la présence d'organes 42, 43, 44 et 45 pouvant être activés ou désactivés sans que le processeur 49 en soit informé. Ce dernier ne peut associer une variation du courant $I_{41}$ mesurée par le capteur 52 à une activation ou désactivation d'un organe $46_{1j}$ ou $46_{2j}$ puisque ces mesures peuvent être perturbées par l'activation ou la désactivation de ces organes 42, 43, 44 ou 45.

Une autre difficulté réside dans le fait que l'alimentation des organes $46_{1j}$ et $46_{2j}$ est assurée, respectivement, via le processeur 51 moteur et via le processeur 49, eux-mêmes consommateurs d'énergie.

Par la suite, les courants d'alimentation transmis aux ensembles $46_1$ d'organes, respectivement $46_2$, seront dénommés $i_{461}$ et $i_{462}$.

La consommation propre des processeurs 48 et 50 est symbolisée par un organe 53 consommant un courant dont l'intensité est égale à la somme des intensités consommées par les unités 48 et 50.

Pour déterminer les variations de courant dues à une variation du fonctionnement d'un organe $46_{1j}$ ou $46_{2j}$, on fait alors appel à deux capteurs 54 et 56 pour mesurer les variations des courants d'alimentation $i_{461}$ ou $i_{462}$ lors d'une activation ou d'une désactivation d'un organe $46_{1j}$ ou $46_{2j}$. Le capteur 54, placé sur l'alimentation de l'ensemble $46_2$ mesure l'intensité $i_{462}$ tandis que le capteur 56 mesure l'intensité $i_{461}$. Ainsi, on mesure les variations de courant entraînées par l'activation ou la désactivation d'organes $46_{1j}$ et/ou $46_{2j}$, ces derniers étant contrôlés en comparant les variations de courant mesurées avec les variations attendues.

Le processeur 49 commande toute modification dans le fonctionnement des organes $46_{1j}$ ou $46_{2j}$. Ce processeur 49 est connecté aux capteurs 54 ou 56 via le réseau d'alimentation pour recevoir de ces capteurs les mesures de courant effectuées. Dans une autre réalisation (non représentée), ces mesures sont transmises par un réseau de commande reliant ces capteurs 54 ou 56 au processeur 49.

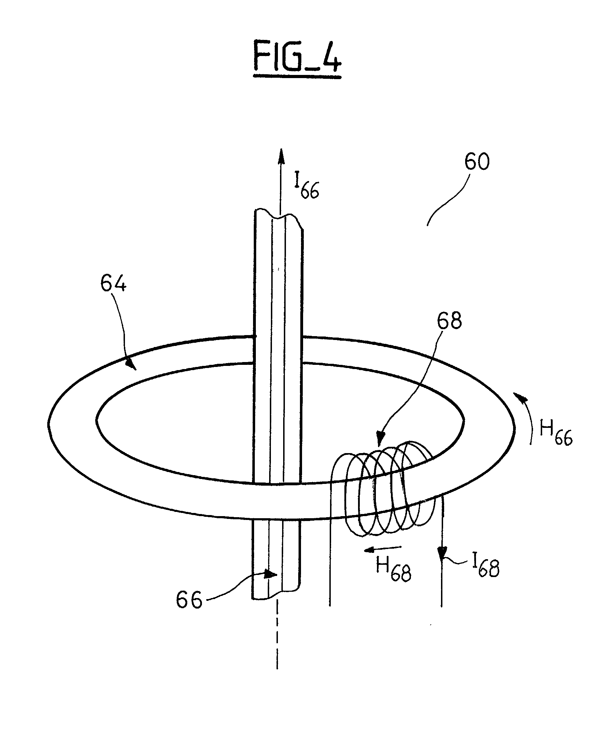

Dans cette réalisation préférée, les capteurs comportent un détecteur de courant et un conditionneur comme décrit, par exemple, dans le préambule de la demande de brevet FR 9900235. Plus précisément, un détecteur 60 (figure 4) comprend un tore magnétique 64 entourant un conducteur 66 parcouru par un courant $I_{66}$ à mesurer. Lorsque le courant $I_{66}$ circule dans le conducteur 66, un champ magnétique $H_{66}$ apparaît dans le tore magnétique.

Le détecteur 60 comprend aussi une bobine 68 entourant le tore 64. Lorsque le champ magnétique $H_{66}$ apparaît dans le tore, un courant de compensation $I_{68}$ circule dans la bobine 68 et créé un deuxième champ magnétique $H_{68}$ s'opposant au premier champ magnétique $H_{66}$. Ce courant de compensation est régulé grâce à la tension aux bornes de la bobine 68 pour obtenir la compensation des champs, c'est-à-dire pour que $H_{68} = H_{66}$, ou $N.I_{68} = I_{66}$, N étant le nombre de spires de la bobine 68.

En effet, la compensation entre le courant mesuré $I_{66}$ et le courant de la bobine $I_{68}$ est détectée en mesurant la tension e résultant du champ magnétique dans le tore ($e=\frac{-dH}{dt}$, où dH = $H_{68}$-$H_{66}$).

Un conditionneur (non montré) associé à cette sonde détecte la tension e, maintient le courant $I_{68}$ compensant le courant $I_{66}$ et délivre un signal transmettant la mesure de la tension.

Lorsque plusieurs capteurs sont utilisés, un même conditionneur peut traiter les signaux transmis par plusieurs sondes. Pour cela, le conditionneur est relié à chaque sonde et partage son temps d'analyse avec les différents signaux transmis par chaque sonde. Ainsi, dans l'exemple de la figure 3, les capteurs 52, 54 et 56 peuvent être des sondes telles que décrites en relation avec la figure 4 qui transmettent des mesures de courant à un conditionneur situé dans l'unité centrale 48. Un tel partage diminue le coût du dispositif de mesure.

Les mesures de courants effectuées par les sondes 52, 54 ou 56 étant transmises au processeur 49, ce dernier contrôle le fonctionnement d'organes $46_{1i}$ et $46_{2j}$, dès que leur fonctionnement est modifié par une commande.

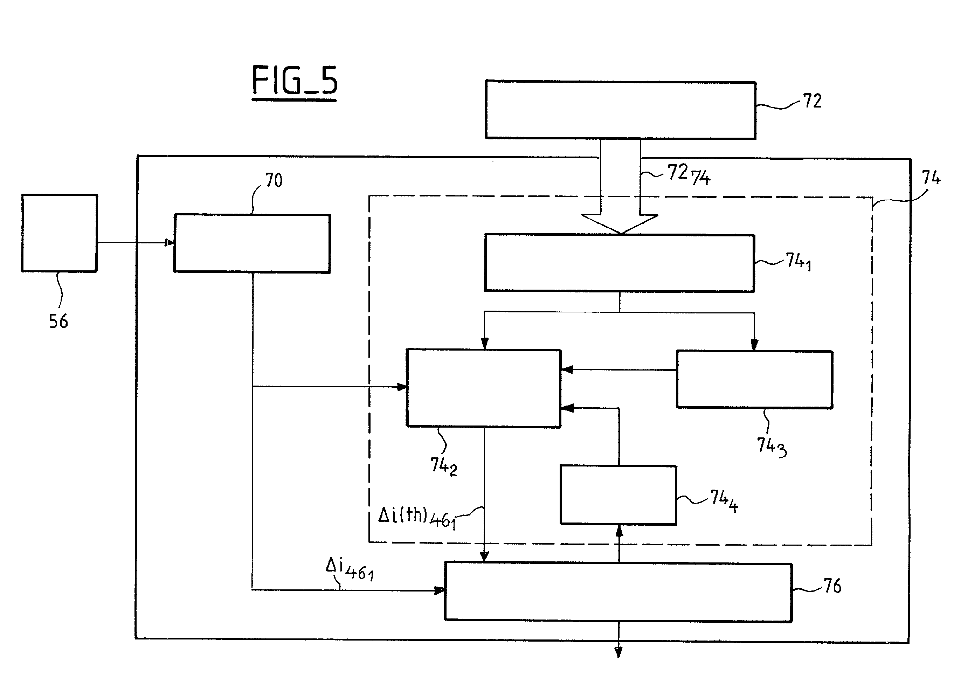

Ces contrôles font appel à des opérations similaires pour l'ensemble d'organes $46_1$ et pour l'ensemble d'organes $46_2$. Ces opérations sont décrites ci-dessous, à l'aide de la figure 5, en considérant uniquement le contrôle des organes de l'ensemble $46_1$.

Une première opération 70 enregistre les me-

sures du courant $i_{461}$ effectuées par la sonde 56 puis évalue ses variations $\Delta i_{461}$. Ces enregistrements s'effectuent avec une fréquence résultant d'un compromis entre la charge de traitement de l'unité 48 et la précision requise pour évaluer $\Delta i_{461}$. Par ailleurs, ces évaluations déterminent les périodes où le courant $i_{461}$ est constant ($\Delta i_{461}=0$).

Une opération 74 détermine la variation théorique $\Delta i(th)_{461}$ du courant $i_{461}$ correspondant à une commande 72 d'activation ou de désactivation d'un organe $46_{1g}$. A cet effet, cette commande 72, transmise par un signal $72_{74}$, est enregistrée lors d'une opération $74_1$.

Cette mémorisation des commandes permet de calculer le courant théorique $i(th)_{461}$ nécessaire à l'ensemble $46_1$ à tout instant par une opération $74_2$. Ce courant $i(th)_{461}$ est la somme des courants $i(th)_{461i}$ nécessaires au fonctionnement des organes $46_{1i}$ activés. De ce fait, si un organe $46_{1g}$ est activé par la commande 72, l'estimation du courant $i(th)_{461}$ augmente d'une valeur $i_{461g}$. On réduit la charge de travail de l'unité centrale 48 en n'effectuant cette opération $74_2$ que si le courant $i_{461}$ mesuré est stable, ceci étant déterminé lors de l'opération 70.

Une opération $74_3$ modifie la valeur de l'estimation théorique de $\Delta i(th)_{461}$ lorsque des situations particulières apparaissent telles que l'activation/désactivation rapide d'un organe, par exemple lors d'appels de phares. Dans ce cas précis, on évite que la commande d'activation soit prise en considération dans le calcul du courant d'alimentation car l'activation fugitive des feux empêche le courant de se stabiliser à une intensité correspondant à un mode activé.

Au cours d'une opération 76 de comparaison, la variation $\Delta i_{461}$ mesurée est comparée à la variation $\Delta i(th)_{461}$ calculée. Si cette comparaison montre que les deux valeurs sont suffisamment proches, l'opération 76 diagnostique un fonctionnement correct de l'organe $46_{1g}$ commandé.

La chronologie des opérations 70 et 74 peut être telle que la comparaison 76 entre la valeur mesurée $\Delta i_{461}$ et la valeur calculée $\Delta i(th)_{461}$ n'ait pas de sens, par exemple si la stabilisation du courant d'alimentation après une commande requiert un délai particulièrement long. On effectue alors une opération $74_4$ de retardement pour comparer la valeur $\Delta i(th)_{461}$ attendue à une valeur $\Delta i_{461}$ postérieurement obtenue, comme décrit ultérieurement.

La détermination de l'écart admis entre la variation attendue $\Delta i(th)_{461}$ et la variation mesurée $\Delta i_{461}$ doit tenir compte de l'incertitude ou tolérance de fonctionnement $\Delta I_{46j}$ du courant d'alimentation, par exemple due à chaque organe $46_{1j}$ en fonctionnement.

En supposant que les organes $46_{1l}$ et $46_{1m}$ consomment un même courant d'intensité $i_{461l}$, ces organes peuvent avoir différentes tolérances respectives $\Delta I(46_{1l})$ et $\Delta I(46_{1m})$ de courant d'alimentation consommé. La détection de l'activation ou de la désactivation d'un organe $46_{1i}$ requiert alors que la variation d'intensité $\Delta i_{461}$ du courant lors de ces opérations soit supérieure aux tolérances de courant lors du fonctionnement normal des organes $46_{1l}$ et $46_{1m}$. En d'autres termes :

$$\Delta i_{461} = i46_{1i} > |\Delta I_{461l}| + |\Delta I_{461m}|$$

Dans le cas où $k>i$ organes électriques fonctionnent, une modification du fonctionnement de l'organe $46_{1i}$ sera détectée si :

$$i_{461i} > |\Delta I_{4611}| + |\Delta I_{4612}| + ... + |\Delta I_{461k}|.$$

Comme précédemment indiqué, des délais nécessaires à l'exécution des opérations préalablement identifiées doivent être pris en compte. Ces délais sont les suivants :

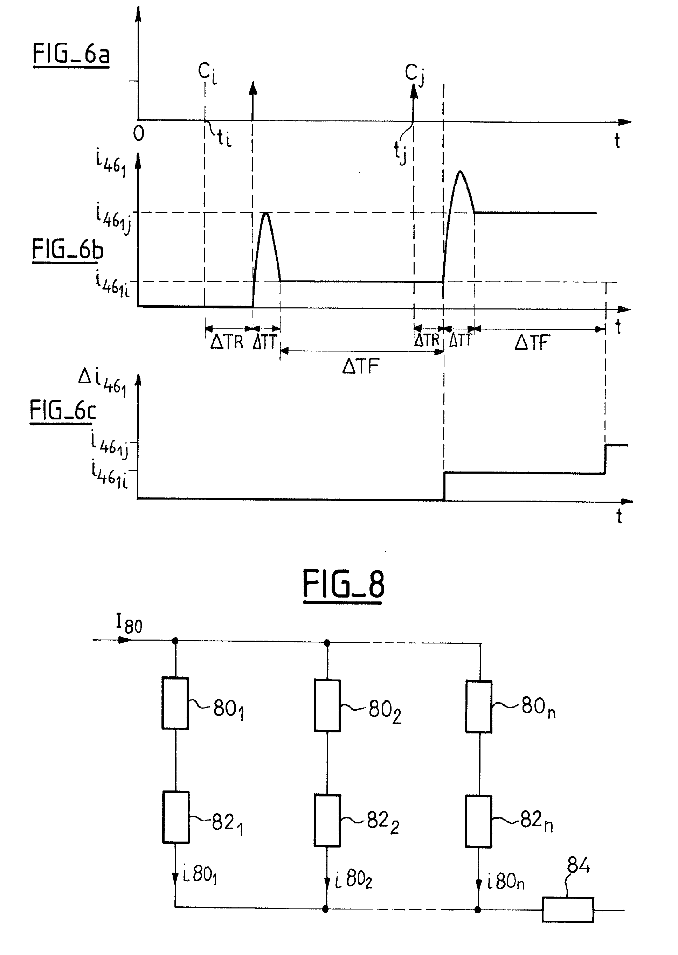

Un premier délai $\Delta TR$ est le retard nécessaire à tout organe pour recevoir une commande transmise à, ou émise par, l'unité centrale à un instant t ; ce délai $\Delta TR$ est par la suite considéré identique pour tous les organes commandés. Ainsi, comme montré sur la figure 6a, une première commande d'activation $C_i$ (figure 6a) d'un organe $46_{1i}$ et une deuxième commande $C_j$ d'activation d'un organe $46_{1j}$, émises par l'unité centrale 48 à des instants respectifs $t_i$ et $t_j$, ne sont reçues par les organes concernés qu'à des instants $t_i+\Delta TR$ et $t_j+\Delta TR$.

Un second délai $\Delta TT$ de transition est requis par chaque organe pour se stabiliser après l'exécution de la commande. Pendant cette période de transition $\Delta TT$, le courant consommé par un organe est variable et les mesures du courant effectuées pendant cette période ne sont pas prises en considération pour contrôler l'organe. Comme représenté sur la figure 6b, l'organe $46_{1i}$ est en régime transitoire pendant la période $t_i+\Delta TR$ à $t_i+\Delta TR+\Delta TT$. De même, l'organe $46_{1j}$ est en régime transitoire pendant la période $t_j+\Delta TR$ à $t_j+\Delta TR+\Delta TT$.

Un troisième délai est une durée $\Delta TF$ de contrôle au cours de laquelle le courant mesuré doit être stable pour que sa mesure soit prise en considération dans les opérations de contrôle. En conséquence, comme représenté sur la figure 6c, la variation de courant mesuré $\Delta i_{461}$ n'est établie qu'après une stabilisation du courant postérieur à une commande pendant une durée $\Delta TF$.

Compte tenu de ces délais, on peut déterminer avec précision le cas où deux commandes $C_i$ et $C_j$ sont émises de façon suffisamment éloignée pour que chacune de ces commandes donne lieu au contrôle d'un organe, ou si ces deux commandes se succèdent trop rapidement pour effectuer ces contrôles.

Dans le premier cas, la première commande $C_i$ est exécutée et contrôlée avant que la deuxième commande ne soit émise. En d'autres termes, la commande $C_i$ est émise à un instant $t_i$ et la commande $C_j$ est émise à un instant $t_j$ tels que $t_j-t_i > \Delta TR+\Delta TT+\Delta TF$. Le contrôle des organes $46_{1i}$ et $46_{1j}$ s'effectue alors en

succession

Si $t_j - t_i < \Delta TR + \Delta TT + \Delta TF$, le contrôle d'un organe ne peut avoir lieu puisque, pendant le délai de contrôle $\Delta TF$ de la première commande, le courant d'alimentation varie du fait de l'exécution de la deuxième commande.

L'analyse des mesures de courant utilise, dans une réalisation préférée, une transformée de Fourier discrète. Cette transformation permet de déterminer la stabilité du courant mesuré tout en filtrant des signaux parasites.

La transformée de Fourier discrète associe à un ensemble de mesures comprises dans un intervalle de temps $\Delta TF$ un groupe de signaux S(0), S(1), S(2), ... et S(N) de fréquences multiples, S(i) désignant un signal de fréquence $f' = i*f$, f étant une fréquence d'échantillonnage prédéterminée.

La valeur du courant mesuré $I_M$, pendant l'intervalle de temps $\Delta TF$, est déterminée à partir de ces signaux S(0), S(1) ... lorsque la valeur mesurée $I_M$ est constante pendant le délai $\Delta TF$. Dans ce cas seul le signal S(0) constant est non nul et la valeur de $I_M$ est égale au module de S(0).

Inversement, on détecte les périodes $\Delta TF$ où l'intensité mesurée $I_M$ est constante en vérifiant que tous les signaux S(i), i étant non nul, sont égaux à zéro.

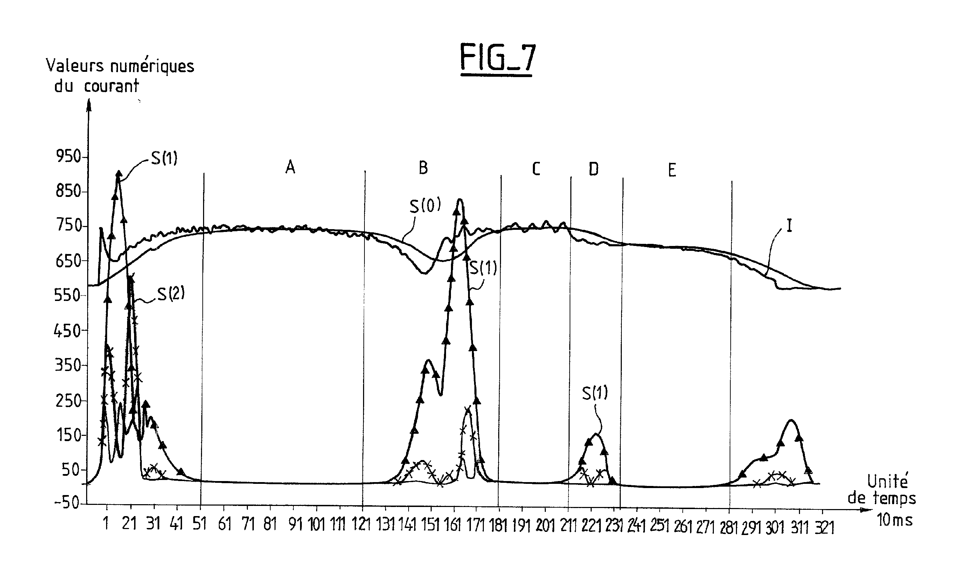

La figure 7 est un diagramme représentant une intensité de courant (en ordonnées) en fonction du temps (en abscisses). Cette intensité, qui correspond au fonctionnement d'un essuie-glace, est déterminée toutes les 10 ms à partir des 20 dernières valeurs mesurées, une nouvelle valeur étant mesurée chaque 10 millisecondes. La transformée de Fourier s'effectue donc sur une période de contrôle $\Delta TF$ de 200 ms.

On voit sur ce diagramme que pendant les périodes A, C et E, de durées supérieures à 200 ms, les harmoniques S(1), S(2) et S(3) sont nulles. Ces périodes peuvent donc être prises en compte pour les mesures de courant. Ce dernier est représenté par S(0). Par contre, au cours des périodes B et D le courant n'est pas constant, les harmoniques S(1) et S(2) n'étant pas nulles, et on ne peut donc pas tenir comptes des mesures.

Le traitement du signal par transformée de Fourier présente en outre l'avantage de filtrer les mesures effectuées par le détecteur 34 (figure 2) vis-à-vis de perturbations. En effet ces perturbations étant principalement irrégulières, elles n'influent que sur les valeurs des signaux S(1), S(2), ... et S(N), et non sur S(0). Or la valeur du courant mesurée est prise en considération lorsque ces signaux sont nuls.

L'invention est susceptible de nombreuses variantes. Par exemple, on peut faire appel à une unité centrale auxiliaire qui ne commande pas les organes électriques mais qui est informée de l'état de commande de ces organes. Dès lors, cette unité centrale peut contrôler ces organes conformément à l'invention à partir des mesures du courant d'alimentation de ces organes.

Par ailleurs, il convient de considérer les chutes d'alimentation dues aux connections multiples, aux connecteurs et à l'évolution des connexions avec le temps (oxydation des contacts). Ces variations peuvent être étudiées expérimentalement, modélisées et introduites lors des opérations de contrôle par une mise à jour de la programmation de l'unité centrale.

En outre, il est clair que l'invention s'applique lors de l'activation, de la désactivation et/ou de toute autre modification du fonctionnement d'un organe électrique entraînant une variation de son alimentation.

Dans une réalisation de l'invention, chaque organe électrique est associé à des oscillateurs pour que, lors du fonctionnement de l'organe, un courant alternatif de faible amplitude et de fréquence propre à chaque organe circule dans une partie commune du réseau d'alimentation des organes. De façon générale, à chaque organe est associé un signal spécifique à cet organe.

Un dispositif fonctionnant suivant ce principe est représenté à la figure 8. Sur cette figure, on a représenté des organes $80_1$, $80_2$ ... $80_n$ alimentés par un courant $I_{80}$. A chaque organe $80_k$ est associé un oscillateur $82_k$ qui génère un courant $i_{80k}$ alternatif et de faible amplitude par rapport à $I_{80}$ lorsque l'organe $80_k$ est activé.

Chaque courant $i_{80}$ se superpose alors au courant $I_{80}$ de telle sorte que, en effectuant un filtrage ou une analyse spectrale du courant d'alimentation $I_{80}$, on détecte chaque composante alternative du courant et la fréquence associée. Par exemple, on peut combiner l'utilisation d'un traitement par Transformée de Fourier pour détecter la stabilité d'un courant et pour effectuer le filtrage.

Le fonctionnement d'un organe $80_k$ est alors contrôlé en vérifiant que l'apparition ou la disparition du courant $i_{80k}$ correspond à l'émission de commandes, respectivement d'activation ou de désactivation, vis-à-vis de cet organe. En outre, on peut détecter la défaillance d'un organe à tout instant, sans qu'il soit nécessaire d'émettre une commande de cet organe.

Ainsi ce mode de réalisation permet un contrôle permanent des derniers organes alors qu'avec l'exemple décrit avec les figures 2 et 3 le contrôle ne s'effectue que lors d'une activation ou désactivation d'un organe.

## Revendications

1. Procédé de contrôle d'organes ($32_j$, $46_{1j}$, $46_{2j'}$) embarqués dans un véhicule (30, 40) comprenant au moins une batterie (29, 41) pour alimenter ces organes ($32_j$, $46_{1j}$, $46_{2j'}$) en énergie électrique et une unité centrale (35, 49) pour mémoriser les commandes transmises à ces derniers,

    **caractérisé en ce qu'**on mesure sur un conducteur ($C_{31}$) d'alimentation reliant la batterie (29) aux organes ($32_j$) commandés au moins un signal représentatif de l'état de fonctionnement de ces or-

ganes ($32_j$) et **en ce qu'**on compare cet état à l'état de fonctionnement déterminé par les commandes mémorisées dans l'unité centrale (35, 49, 51).

**2.** Procédé selon la revendication 1 **caractérisé en ce que** le signal représentant l'état de fonctionnement est l'intensité du courant ($I_{31}$, $i_{461}$, $i46_2$) électrique fourni par la batterie (29, 41).

**3.** Procédé selon la revendication 1 ou 2 **caractérisé en ce que** le signal représentant l'état de fonctionnement est la variation de l'intensité du courant ($I_{31}$, $i_{461}$, $i46_2$) fourni par la batterie (29, 41) quand un organe ($32_j$, $46_{1j}$, $46_{2j'}$) contrôlé est activé ou désactivé.

**4.** Procédé selon la revendication 2 ou 3 **caractérisé en ce que** la détermination de l'intensité du courant ($I_{31}$, $i_{461}$, $i46_2$) n'est prise en compte que lorsque cette intensité est stable sur une période prédéterminée.

**5.** Procédé selon la revendication 4 **caractérisé en ce que**, pour détecter la stabilité du courant ($I_{31}$, $i_{461}$, $i46_2$), on effectue une analyse spectrale de ce dernier, par exemple par une Transformée de Fourier Discrète, le signal étant considéré stable quand les harmoniques sont nuls ou négligeables.

**6.** Procédé selon l'une des revendications 3 à 5 **caractérisé en ce que**, le véhicule (30, 40) comportant des organes (42, 43, 44, 45) pour lesquels les commandes ne sont pas mémorisées dans l'unité centrale (35), l'intensité du courant ($I_{31}$, $i_{461}$, $i46_2$) est détectée dans une dérivation alimentant uniquement des organes contrôlés.

**7.** Procédé selon l'une des revendications 3 à 6 **caractérisé en ce qu'**on prend en compte des délais prédéterminés de réception des signaux de commande par les organes ($32_j$, $46_{1j}$, $46_{2j'}$) commandés et des délais de stabilisation du courant ($I_{31}$, $i_{461}$, $i46_2$) avant de déterminer une mesure du courant, de telle sorte que si ces délais ne sont pas respectés, le contrôle est retardé ou annulé.

**8.** Procédé selon l'une des revendications 3 à 7 **caractérisé en ce qu'**on prend en compte des incertitudes ou tolérances du courant ($I_{31}$, $i_{461}$, $i46_2$), par exemple dues aux organes en fonctionnement, de telle sorte que la variation de courant n'est considérée dans le contrôle d'un organe $32_j$, $46_{1j}$, $46_{2j'}$) que si elle est supérieure à ces incertitudes ou tolérances.

**9.** Procédé selon l'une des revendications précédentes **caractérisé en ce qu'**à chaque organe ($80_j$) on affecte un signal caractéristique transmis sur le conducteur d'alimentation, ce signal étant présent (ou absent) lorsque l'organe ($80_j$) est activé et absent (ou présent) lorsque l'organe ($80_j$) est désactivé.

**10.** Procédé selon la revendication 9 **caractérisé en ce que** le signal caractéristique est un signal à fréquence constante, cette fréquence étant propre à un organe.

**11.** Procédé selon les revendications 5 et 10 **caractérisé en ce que** l'analyse spectrale est aussi utilisée pour détecter les fréquences propres aux organes.

**12.** Procédé selon l'une des revendications précédentes **caractérisé en ce qu'**on commande les organes ($32_j$, $46_{1j}$, $46_{2j'}$, $80_j$) à partir de l'unité centrale.

**13.** Procédé selon l'une des revendications précédentes **caractérisé en ce que** la comparaison entre l'état de fonctionnement déterminé à partir du signal prélevé et l'état de fonctionnement mémorisé est effectuée dans l'unité centrale.

**14.** Véhicule (30, 40) comprenant une batterie (29, 41) pour alimenter ces organes ($32_j$, $46_{1j}$, $46_{2j'}$) en énergie électrique et une unité centrale (35, 49) pour mémoriser les commandes transmises à ces derniers, **caractérisé en ce qu'**il comprend des moyens pour la mise en oeuvre du procédé conforme à l'une des revendications précédentes.

**15.** Dispositif de contrôle et d'alimentation électrique d'organes à bord d'un véhicule (30, 40), comprenant une batterie (29, 41) pour alimenter ces organes ($32_j$, $46_{1j}$, $46_{2j'}$) en énergie électrique et une unité centrale (35, 49) pour mémoriser les commandes transmises, **caractérisé en ce qu'**il comprend des moyens pour la mise en oeuvre du procédé conforme à l'une des revendications 1 à 13.

## FIG_1

10
18
$17_{12}$
$21_{12}$
$I_{12}$
12
$C_{12}$
$19_{12}$ $17_{14}$
$I_{14}$
$21_{14}$
$C_{14}$
14
$19_{14}$ $17_{16}$
$I_{16}$
$21_{16}$
$C_{16}$
16
$19_{16}$

## FIG_2

30
29
34
35
$32_1$
$32_2$
31
$I_{31}$
$C_{31}$
$31_1$
$31_2$
$32_i$
$C_{34}$
$B_{36}$
$31_i$
36
$C_{36}$
$31_n$
$32_n$

FIG_3

EP 1 291 661 A1

# FIG_4

## FIG_5

EP 1 291 661 A1

$\Delta i(th)_{461}$

$\Delta i_{461}$

56 70 72 74 76 $74_1$ $72_{74}$ $74_2$ $74_3$ $74_4$

FIG_6a

$C_i$

O $t_i$

$C_j$

$t_j$

t

FIG_6b

$i_{46_1}$

$i_{46_1j}$

$i_{46_1i}$

ΔTR ΔTT

ΔTF

ΔTR ΔTT

ΔTF

t

FIG_6c

$\Delta i_{46_1}$

$i_{46_1j}$

$i_{46_1i}$

t

# FIG_8

$I_{80}$

$80_1$

$80_2$

$80_n$

$82_1$

$82_2$

$82_n$

$i\,80_1$

$i\,80_2$

$i\,80_n$

84

FIG_7

# EP 1 291 661 A1

**Office européen des brevets**

## RAPPORT DE RECHERCHE EUROPEENNE

Numéro de la demande

EP 02 29 2182

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y | EP 0 762 135 A (SUN ELECTRIC UK) 12 mars 1997 (1997-03-12) * page 2, colonne 1, ligne 50 - colonne 2, ligne 6 * * page 3, colonne 3, ligne 6 - ligne 13; figures 8-11 * | 1,14,15 | G01R31/00 |
| Y | EP 0 398 481 A (FORD) 22 novembre 1990 (1990-11-22) * abrégé * * revendications; figures * | 1,14,15 | |
| A | US 5 550 762 A (DOLL) 27 août 1996 (1996-08-27) * abrégé * * colonne 7, ligne 34 - ligne 51; figures * | 1,14,15 | |
| A | FR 2 595 829 A (NERO ET AL.) 18 septembre 1987 (1987-09-18) * abrégé * * page 2, colonne 13, alinéa 20; figures * | 1,14,15 | DOMAINES TECHNIQUES RECHERCHES (Int.Cl.7) G01R |
| A | US 3 629 695 A (TAYLOR ET AL.) 21 décembre 1971 (1971-12-21) * colonne 1, ligne 21 - colonne 2, ligne 16; figures * | 1,14,15 | |

Le présent rapport a été établi pour toutes les revendications

| Lieu de la recherche | Date d'achèvement de la recherche | Examinateur |
|---|---|---|
| BERLIN | 26 novembre 2002 | Kempen, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**          EP 02 29 2182

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-11-2002

| Document brevet cité au rapport de recherche | | Date de publication | Membre(s) de la famille de brevet(s) | | Date de publication |
|---|---|---|---|---|---|
| EP 762135 | A | 12-03-1997 | EP | 0762135 A2 | 12-03-1997 |
| | | | US | 6157877 A | 05-12-2000 |
| | | | US | 5818574 A | 06-10-1998 |
| EP 398481 | A | 22-11-1990 | DE | 69028872 D1 | 21-11-1996 |
| | | | DE | 69028872 T2 | 20-02-1997 |
| | | | EP | 0398481 A2 | 22-11-1990 |
| | | | US | 5041976 A | 20-08-1991 |
| US 5550762 | A | 27-08-1996 | AUCUN | | |
| FR 2595829 | A | 18-09-1987 | FR | 2595829 A1 | 18-09-1987 |
| US 3629695 | A | 21-12-1971 | AUCUN | | |

EPO FORM P0460

Pour tout renseignement concernant cette annexe : voir Journal Officiel de l'Office européen des brevets, No.12/82